# EUROPEAN PATENT APPLICATION

(11) **EP 4 287 239 A1**
(43) Date of publication of application: **06.12.2023**
(21) Application number: 22176943.3
(22) Date of filing: 02.06.2022
(51) Int. Cl.: H01L 21/02, H01L 21/762

(54) **A LOW LOSS SEMICONDUCTOR SUBSTRATE**

(71) Applicant: Imec VZW, 3001 Leuven (BE)
(72) Inventor: Parvais, Bertrand, 3001 Leuven (BE); Yadav, Sachin, 3001 Leuven (BE); Zhao, Ming, 3001 Leuven (BE); Cardinael, Pieter, 3001 Leuven (BE)
(74) Representative: Patent Department IMEC

(57) **Abstract**

A substrate (1) according to the invention comprises a base substrate (2), a dielectric layer (3), a trap-rich layer (4) on the dielectric layer, and a crystalline semiconductor layer (5) on the trap-rich layer. The dielectric layer (3) may be a stack of multiple dielectric sublayers formed of the same dielectric material or formed of two or more different dielectric materials. The substrate of the invention is suitable for epitaxially growing on the surface of the crystalline semiconductor layer (5) one or more layers (6,7,8) of a compound semiconductor. The preferred application is the growth of a stack of layers of III-V material with one or more upper layers of the stack being suitable for processing in and/or on said layers a number of semiconductor devices such as transistors or diodes. The position of the trap-rich layer (4), between the dielectric layer (3) and the crystalline semiconductor layer (5), enables the neutralization of a parasitic surface conductive layer at the interface between the crystalline layer (5) and the compound layer or layers (6,7,8), and of an additional PSC layer caused by a direct contact between the crystalline layer (5) and the dielectric layer (3). The invention is equally related to methods for producing the substrate of the invention.

## Description

### Field of the Invention

The present invention is related to semiconductor processing, in particular to a substrate suitable for producing thereon an epitaxially grown stack of compound semiconductor layers such as layers formed of AIN, GaN, AIGaN, GaAs, InP, GaSb or other III-V materials.

### State of the art.

The epitaxial growth of compound semiconductors, in particular III-V materials on silicon has been a widely researched field in view of present and future generations of substrates suitable for the fabrication of high-performance semiconductor devices. Notably radio-frequency (RF) applications will increasingly require III-V materials because of their superior low-noise and high power characteristics as compared to their silicon CMOS counterparts. Consequently, implementation of low-noise amplifiers, power amplifiers, and switches for RF front-end-of-module (FEM) can be based on III-V materials for 5G and beyond wireless applications.

Integration of III-V materials such as GaN, GaAs, and InP on a large-area silicon substrate is a key to achieve low cost, high volume production. In order to minimize RF losses in the substrate and to achieve good switch linearity, the III-V materials are grown on a high resistivity crystalline silicon layer, which may for example be the active Si layer of an SOI (silicon-on-insulator) substrate. Nevertheless, it is well known that the resistivity of the Si layer decreases as a consequence of III-V material diffusing in the Si during the high-temperature epitaxial growth of the material. The diffused III-V material has the effect of doping the Si, thereby causing the formation of a parasitic surface conductive (PSC) layer located in the high resistivity Si layer, at the interface between the Si and the III-V layer stack. This PSC layer is a root cause of the majority of RF losses and harmonic generation in the high resistivity substrate.

The typical solution applied to mitigate the PSC layers is the formation of a trap rich (TR) layer. It is known to form a TR layer underneath the oxide layer of an SOI wafer, to thereby neutralize free charges in the base substrate of the SOI wafer, when RF circuitry is formed directly on the Si top layer of the SOI. This is however not a solution for mitigating the losses caused by the formation of III-V layers on said Si top layer.

Patent publication document US2016/0351666 describes a method for forming a trap rich layer at the interface between the high resistivity Si and the III-V stack, by irradiating the substrate with a laser after the epitaxial growth of the III-V material. This is a complex method and the impact of the laser on the substrate characteristics may be unpredictable. In addition, the inventors of the present invention have found that the doping of the Si by diffusion of III-V material is not the only source of reduced resistivity in a high resistivity Si layer formed on top of a dielectric layer such as a layer of silicon oxide. It was found that positive charges appear in the oxide layer, which are compensated by negative charges in the Si layer, resulting in a PSC at the oxide/Si interface. It is at least doubtful whether the negative effect of this PSC is mitigated by the approach described in US2016/0351666.

### Summary of the invention

The invention aims to provide a solution to the above-described problems. This aim is achieved by a substrate and by production methods in accordance with the appended claims.

A substrate according to the invention comprises a base substrate, a dielectric layer, a trap-rich layer on the dielectric layer, and a crystalline semiconductor layer on the trap-rich layer. The dielectric layer may be a stack of multiple dielectric sublayers formed of the same dielectric material or formed of two or more different dielectric materials. The substrate of the invention is suitable for epitaxially growing on the surface of the crystalline semiconductor layer one or more layers of a compound semiconductor. The preferred application is the growth of a stack of layers of III-V material with one or more upper layers of the stack being suitable for processing in and/or on said layers a number of semiconductor devices such as transistors or diodes. Such III-V materials are known as such, and well-known examples include GaN, GaAs, InP, GaSb or others. The position of the trap-rich layer, between the dielectric layer and the crystalline semiconductor layer, enables the neutralization of a parasitic surface conductive layer at the interface between the crystalline layer and the compound layer or layers, and of an additional PSC layer caused by a direct contact between the crystalline layer and the dielectric layer.

Hence the substrate of the invention is a low loss substrate, i.e. a substrate that prevents RF energy loss when active devices are produced on the compound semiconductor layers. This is particularly useful in the case of RF devices and circuits fabricated on III-V layers formed on a substrate according to the invention. The invention is equally related to methods for producing the substrate of the invention.

The invention is thus related to a substrate suitable for growing thereon one or more compound semiconductor layers, the substrate comprising the following consecutive parts, from the bottom of the substrate to the top :
- a base substrate,
- a dielectric layer, which may be a single layer or a stack of multiple dielectric layers,
- a trap-rich layer,
- a crystalline semiconductor layer.

According to an embodiment, the base substrate is a silicon substrate or a ceramic substrate. The substrate may comprise a stack of dielectric layers on the base substrate, said stack comprising a top layer of silicon oxide.

According to an embodiment, the trap-rich layer is a layer of polysilicon. According to an embodiment, the substrate is suitable for growing thereon one or more layers of III-V semiconductor material. The crystalline semiconductor layer may be a crystalline silicon layer.

The invention is also relate to a method for producing a substrate according to any one of the preceding claims, the method comprising the steps of :
- providing a base substrate,
- forming a first dielectric layer on the base substrate,
- providing a crystalline semiconductor substrate,
- forming a trap-rich layer on the crystalline semiconductor substrate,
- optionally forming a second dielectric layer on the trap rich layer,
- bonding the crystalline semiconductor substrate to the base substrate by bonding the second dielectric layer to the first dielectric layer, or by bonding the trap-rich layer directly to the first dielectric layer,
- removing part of the crystalline semiconductor substrate, leaving a layer of crystalline semiconductor material on the trap-rich layer.

According to an embodiment, the method comprises the step of doping the crystalline substrate to create a line of cracks in the substrate, wherein the step of removing part of the crystalline substrate includes removing said part along the line of cracks.

According to an embodiment of the method of the invention, the base substrate is a silicon substrate or a ceramic substrate.

According to an embodiment of the method of the invention, the trap-rich layer is a layer of polysilicon.

According to an embodiment of the method of the invention, the crystalline semiconductor substrate is a crystalline silicon substrate.

The invention is equally related to a semiconductor chip comprising a singulated portion of a substrate according to the invention, the chip comprising one or more semiconductor devices produced from one or more compound semiconductor layers grown on the substrate.

### Brief description of the figures

Figure 1a illustrates a substrate in accordance with an embodiment of the invention.
Figure 1b shows the substrate of Figure 1a, with a stack of III-V materials produced thereon.
Figures 2a to 2d illustrate one embodiment of the method of the invention, for producing the substrate illustrated in Figure 1a.

### Detailed description of the invention

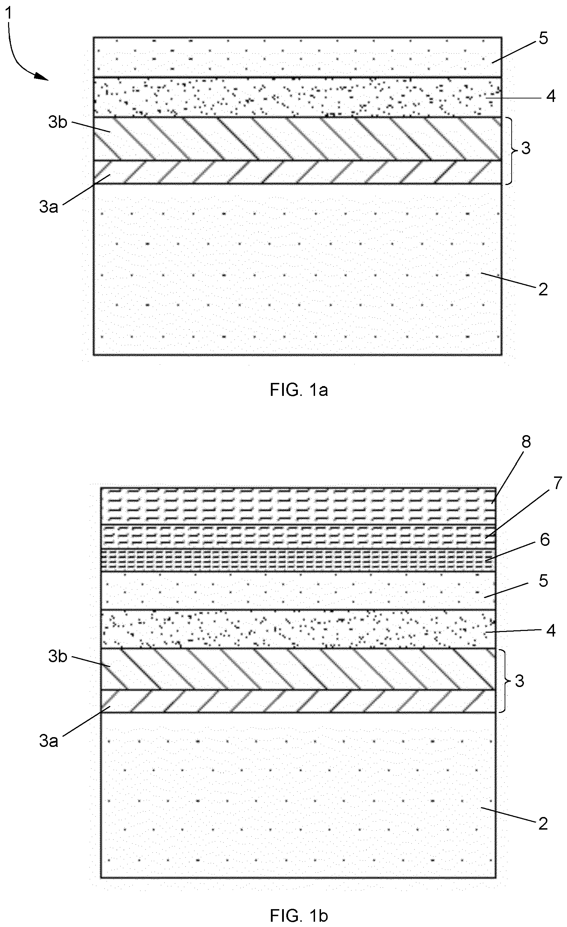

Figure 1a shows a small section of a substrate 1 according to an embodiment of the invention. The substrate may have the planar dimensions of a process wafer, for example a 300 mm diameter wafer. Materials and layer thicknesses mentioned hereafter are cited only by way of example and are not limiting the scope of the invention.

The substrate 1 comprises a crystalline silicon base substrate 2 with a number of layers thereon. Directly on the base substrate 2 is a dielectric layer 3, consisting of a stack of two sublayers 3a and 3b. Layer 3a may for example be a silicon nitride layer or it may itself be a stack of a silicon oxide layer and a silicon nitride layer. In the embodiment shown, layer 3b is a silicon oxide layer. The thickness of each of the layers 3a and 3b may be between a few tens of nanometres up to a few micrometres.

Directly on the dielectric layer 3 is a polycrystalline silicon (polySi) layer 4 which may have a thickness in the order of 1 µm and directly on said polySi layer 4 is a crystalline silicon layer 5 having a thickness in the order of 0.5µm, but preferably below the actual value of 0.5µm. Layer 5 is a high resistance (HR) Si layer, having a resistivity of preferably more than 100 Ω.cm.

Methods to produce the substrate 1 will be described further in this description.

Figure 1b shows the substrate 1 provided with a stack of III-V materials obtained by epitaxial growth. In the embodiment shown, and included merely by way of example, the III-V stack comprises a thin nucleation layer e.g. AIN (not shown) directly on the Si layer 5, followed by a buffer layer 6 and active layers 7 and 8 on the buffer layer, the buffer layer serving to compensate for the difference in lattice constant between the Si layer 5 and the active layers 7,8 of the III-V stack. The buffer layer 6 may be a stack of III-V material such as AIGaN alloy, GaN, AIGaN/AIN superlattice. The active layers may include a channel layer 7 and a barrier layer 8 designed to create a 2-dimensional charge carrier layer at the interface between the channel and the barrier. The channel layer 7 may be formed of defect-free GaN and the barrier layer 8 may be formed of AIGaN, which are typically used for producing a GaN based HEMT (High Electron Mobility Transistor).

The polySi layer 4 acts as a trap-rich layer, i.e. a layer capable of trapping free charges appearing in a given area above or below the trap-rich layer 4. The so-called traps in a polySi layer or in a trap-rich layer formed of other material may be crystal defects or deliberately added dopant elements. In a substrate according to the invention, the trap rich layer 4 is configured, due to its material and thickness, to trap free charges appearing in a PSC layer at the interface between III-V stack 6-7-8 and the crystalline layer 5, thereby neutralizing the PSC layer. At the same time, due to its position between the crystalline layer 5 and the dielectric layer 3, the trap-rich layer 4 enables the neutralization of an additional PSC layer appearing where the crystalline layer 5 is in direct contact with the dielectric layer 3.

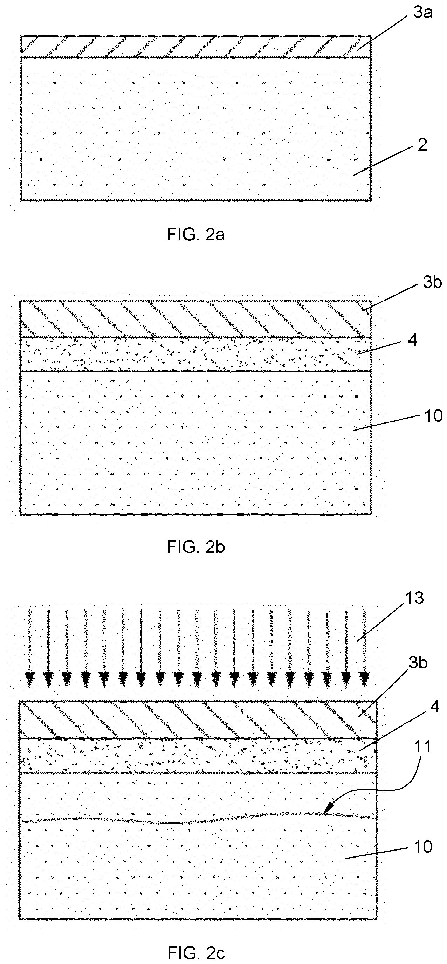

With reference to Figures 2a to 2d, one embodiment of the method for producing the substrate 1 is described hereafter. Once again, materials are cited only by way of example and are not limiting the scope of the invention.

As shown in Figure 2a, the silicon base substrate 2 is provided and the dielectric layer 3a is produced thereon by any suitable technique known in the art, such as chemical vapour deposition (CVD), possibly applying several consecutive layers of different dielectric materials.

With reference to Figure 2b, a high resistance crystalline silicon substrate 10 is then provided and the trap-rich layer 4 of polySi is formed thereon, for example by CVD, followed by the deposition of the silicon oxide layer 3b, for example again by CVD.

As illustrated in Figure 2c, the substrate 10 provided with layers 4 and 3b is subjected to a dopant implantation 13, using hydrogen atoms as dopants. The implant energy and duration are chosen so that the implant causes a zone of small cracks to appear in the crystalline silicon substrate 10, symbolized by the line 11 in Figure 2c.

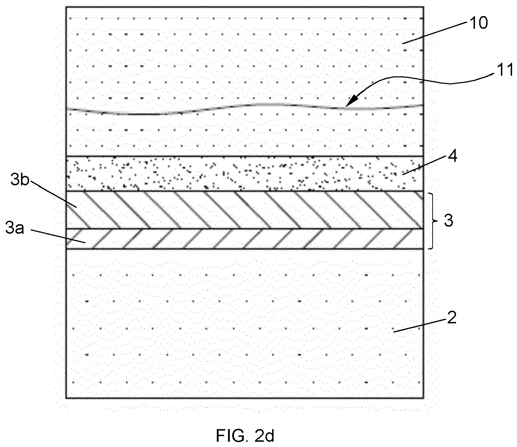

With reference to Figure 2d, the substrate 10 provided with layers 4 and 3b is then flipped and bonded to base substrate 2 by bonding the layer 3b to the layer 3a, by a direct dielectric-to-dielectric bonding step, also known as such in the art. The bulk Si substrate 10 (above the line 11) is then separated using heating and the remaining silicon layer is planarized by chemical mechanical polishing (CMP), leaving a thin crystalline Si layer 5 on top of the polysilicon layer 4, as shown in Figure 1a.

The use of an H-implant to form small cracks in the silicon and the subsequent removal of the silicon substrate along the line of cracks is known as a 'smart cut', and this technique is known in the art. Therefore, details of how to perform this technique are considered known and are not described here in detail. An advantage of using this technique is that the Si-substrate 10 can be re-used for producing additional substrates according to the invention or for other purposes.

The method of the invention is however not limited by the use of the smart cut technique. As an alternative, the Si substrate 10 may be thinned after the bonding step, by grinding followed by chemical mechanical polishing of the silicon from the back side of the substrate 10, until the thin Si layer 5 remains.

As stated, the materials cited above are not limiting the scope of the invention. The base substrate 2 could be a ceramic substrate instead of a silicon substrate. According to preferred embodiments, the base substrate 2 itself also comprises charge traps. This may be realized by a trap-rich crystalline silicon substrate, i.e. a silicon substrate having a trap-rich upper layer, obtainable by techniques known in the art of producing a trap-rich SOI wafer. Alternatively, the base substrate 2 could be formed of quartz or of polycrystalline AIN.

The trap-rich layer 4 could be formed of other materials instead of polySi. It could for example be an oxide layer obtainable by atomic layer deposition (ALD), such as a layer of HfO₂, which exhibits a high interface trap density with Si.

The thickness of the trap-rich layer 4 may vary between a few tens of nanometres up to a few micrometres.

The dielectric layer 3 could be a single layer of a given material, for example obtained by the method described above, but wherein both layers 3a and 3b are formed of silicon oxide. Layers 3a and 3b may then merge during the bonding step to form a substantially uniform silicon oxide layer 3.

According to another embodiment of the method of the invention, no dielectric layer 3b is deposited on the trap rich layer 4 prior to the bonding step, i.e. the trap rich layer 4 is bonded directly to the dielectric layer 3a. This is possible for specific material combinations, for example when the trap rich layer 4 is a layer of HfO₂ and the dielectric layer 3a is a silicon oxide layer or comprises an upper layer formed of silicon oxide.

A substrate in accordance with the invention can be further processed to produce a plurality of semiconductor devices from one or more compound semiconductor layers grown on the substrate. Said further processing can be done by processing steps known as such in the art, for example steps for producing RF devices from III-V layers 6-8 deposited on the substrate 1 illustrated in the drawings. The invention is equally related to a semiconductor chip produced by singulating a substrate in accordance with the invention, after said further processing of the substrate.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A substrate (1) suitable for growing thereon one or more compound semiconductor layers (6,7,8), the substrate comprising the following consecutive parts, from the bottom of the substrate to the top :
- a base substrate (2),
- a dielectric layer (3), which may be a single layer or a stack of multiple dielectric layers,
- a trap-rich layer (4),
- a crystalline semiconductor layer (5).

2. The substrate (1) according to claim 1, wherein the base substrate (2) is a silicon substrate or a ceramic substrate.

3. The substrate (1) according to claim 1 or 2, comprising a stack of dielectric layers (3a,3b) on the base substrate (2), said stack comprising a top layer (3b) of silicon oxide.

4. The substrate (1) according to any one of the preceding claims, wherein the trap-rich layer (4) is a layer of polysilicon.

5. The substrate (1) according to any one of the preceding claims, wherein the substrate is suitable for growing thereon one or more layers (6,7,8) of III-V semiconductor material.

6. The substrate (1) according to any one of the preceding claims, wherein the crystalline semiconductor layer (5) is a crystalline silicon layer.

7. A method for producing a substrate (1) according to any one of the preceding claims, the method comprising the steps of:
- providing a base substrate (2),
- forming a first dielectric layer (3a) on the base substrate (2),
- providing a crystalline semiconductor substrate (10),
- forming a trap-rich layer (4) on the crystalline semiconductor substrate (10),
- optionally forming a second dielectric layer (3b) on the trap rich layer (4),
- bonding the crystalline semiconductor substrate (10) to the base substrate (2) by bonding the second dielectric layer (3b) to the first dielectric layer (3a), or by bonding the trap-rich layer (4) directly to the first dielectric layer (3a),
- removing part of the crystalline semiconductor substrate (10), leaving a layer (5) of crystalline semiconductor material on the trap-rich layer (4).

8. The method according to claim 7, comprising the step of doping the crystalline substrate (10) to create a line (11) of cracks in the substrate, and wherein the step of removing part of the crystalline substrate includes removing said part along the line (11) of cracks.

9. The method according to claim 7 or 8, wherein the base substrate (2) is a silicon substrate or a ceramic substrate.

10. The method according to any one of claims 7 to 9, wherein the trap-rich layer (4) is a layer of polysilicon.

11. The method according to any one of claims 7 to 10, wherein the crystalline semiconductor substrate (10) is a crystalline silicon substrate.

12. A semiconductor chip comprising a singulated portion of a substrate (1) according to any one of claims 1 to 6, the chip comprising one or more semiconductor devices produced from one or more compound semiconductor layers (6-8) grown on the substrate (1).
